# EUROPEAN PATENT SPECIFICATION

(11) **EP 3 934 392 B1**
(45) Date of publication and mention of the grant of the patent: **07.05.2025**
(21) Application number: 21183444.5
(22) Date of filing: 02.07.2021
(51) Int. Cl.: H05K 3/18

(54) **PRINTED CIRCUIT**
LEITERPLATTE
CIRCUIT IMPRIMÉ

(30) Priority: 03.07.2020 ES 202031451 U
(43) Date of publication of application: 05.01.2022
(73) Proprietor: EIKA, S.COOP., 48277 Etxebarria (ES)
(72) Inventor: DE LOS TOYOS LÓPEZ, Daniel, 20600 Eibar (ES); OTEO OLEA, Uxue, 20570 Bergara (ES); BAZTAN ESPARZA, Jesus Javier, 01007 Vitoria-Gasteiz (ES)
(74) Representative: Igartua, Ismael

(56) References cited:
- GB-A- 2 287 472
- US-B1- 10 653 010

## Description

### TECHNICAL FIELD

The present invention relates to printed circuits.

### PRIOR ART

US5308796A describes a method for manufacturing an electronic device having a printed circuit. In the process of manufacturing the printed circuit, copper plating is performed by means of an electrolytic process on a plurality of tracks made of a silicide, palladium silicide for example.

The process described in US5308796A allows the selective plating of copper in the printed circuit, given that copper is deposited only in those regions in which palladium silicide is present.

GB2287472A describes a process for metal deposition on selected areas of an electrically insulating surface. In a first stage of the process, selected areas of the insulating surface are covered using a carbon-based ink by impact, non-impact, electrostatic, xerographic, or other known printing technique. In a second stage of the process, a metal layer is deposited on the printed areas by means of an electroless deposition. Preferably, the metal used in this step includes alone or in any combination copper, nickel, silver and/or gold. After obtaining a sufficient thickness in this stage, in a third stage a second layer of metal is deposited on the first layer by electroplating, this second metal being able to be a similar or different metal. In this way a metallic layer of the necessary thickness is obtained at low cost.

US10653010B1 describes a method for forming a contact pad on a substrate which has a first and a second side. In an embodiment the starting point is a non-conductive substrate on which two layers of conductive ink are printed, one on each side, in which gaps are left such that parts of conductive ink separated by said gaps are electrically insulated. The conductive ink layers are then cured or dried. Two vias are then cut through both the substrate and the two conductive ink layers, both vias being subsequently filled by conductive ink. Overfilling conductive ink on the surfaces of the conductive ink layers provides a larger area for improved contact and/or formation of a contact pad. The conductive ink used to fill the vias may be cured or dried after application. Two non-conductive dielectric layers are then selectively applied to the substrate and both conductive ink layers such that a contact pad can be formed within the non-conductive dielectric layer facilitating the attachment to the conductive ink layer. A contact path can also be formed in a gap within the dielectric layer over the conductive ink filling the vias. US10653010B1 describes the use of Palladium in the conductive ink.

### DISCLOSURE OF THE INVENTION

The object of the invention is to provide a printed circuit as defined in the claims.

The printed circuit of the invention comprises a substrate, and a conductive circuit on at least part of a first face of the substrate, the conductive circuit comprising a catalytic ink layer printed on part of the first face of the substrate, and a first metal layer deposited on the catalytic ink layer. The conductive circuit comprises a second metal layer deposited on the first metal layer. The first metal layer is a nickel layer deposited on the catalytic ink layer by means of an electroless metal plating process, and the second metal layer is a copper layer deposited on the first metal layer by means of a galvanic metal plating process.

The printed circuit comprises an additional conductive circuit on at least part of a second face of the substrate, the additional conductive circuit comprising an additional catalytic ink layer printed by means of the catalytic ink printing process, a first additional metal layer deposited on the additional catalytic ink layer with the first additional metal layer being a nickel layer deposited by means of the electroless metal plating process, and a second additional metal layer deposited on the first additional metal layer with the second additional metal layer being a copper layer deposited by means of the galvanic metal plating process. The substrate comprises a through opening communicating the first face of the substrate with the second face of the substrate.

The printed circuit comprises a catalytic ink connection layer printed on the contour of the opening by means of the catalytic ink printing process, a nickel metal connecting layer deposited by means of the electroless metal plating process on the catalytic ink connection layer printed on the contour of the opening, and a copper metal connecting layer deposited by means of the galvanic metal plating process on the nickel metal connecting layer.

The catalytic ink layer printed on the first face of the substrate and the additional catalytic ink layer printed on the second face of the substrate are electrically connected to one another through the catalytic ink connection layer, with the first metal layer and the first additional metal layer being electrically connected to one another by means of the nickel metal connecting layer, and with the second metal layer and the second additional metal layer being electrically connected to one another by means of the copper metal connecting layer.

The existence of the first nickel metal layer causes the conductivity of the conductive circuit of the printed circuit of the invention to be better than the conductivity of this same kind of conductive circuits known in the state of the art.

These and other advantages and features of the invention will become apparent in view of the figures and detailed description of the invention.

### DESCRIPTION OF THE DRAWINGS

Figure 1 shows a section view of a printed circuit according to the invention from a first perspective.
Figure 2 shows a section view of the printed circuit of Figure 1 from a second perspective.
Figure 3 shows a section view of another embodiment of the printed circuit of Figure 1.

### DETAILED DISCLOSURE OF THE INVENTION

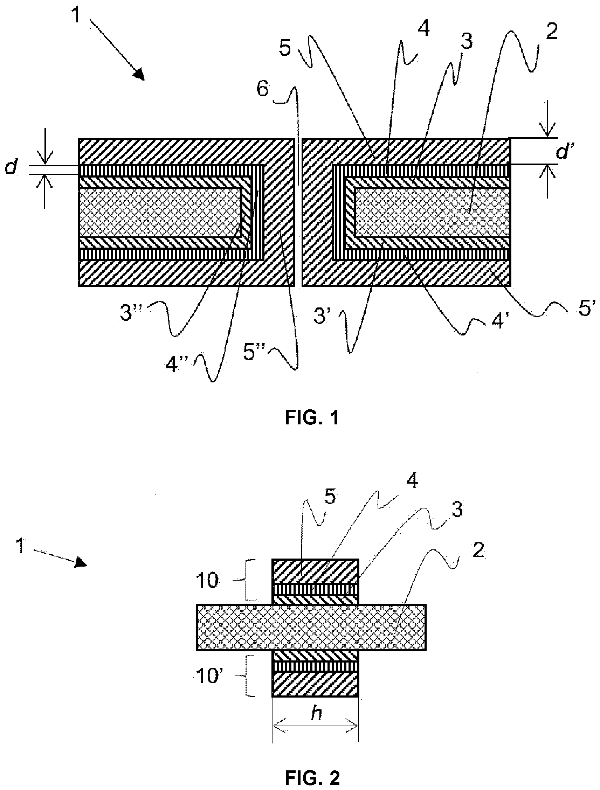

Figures 1 and 2 refer to a preferred embodiment of the printed circuit 1 according to the invention.

The printed circuit 1 of the invention comprises a substrate 2 and a conductive circuit 10 on at least part of a first face of the substrate 2, the conductive circuit 10 comprising a catalytic ink layer 3 printed on part of the first face of the substrate 2 and a first metal layer 4 deposited on the catalytic ink layer 3. The conductive circuit 10 comprises a second metal layer 5 deposited on the first metal layer 4. The first metal layer 4 is a nickel layer deposited on the catalytic ink layer 3 by means of an electroless metal plating process, and the second metal layer 5 is a copper layer deposited on the first metal layer 4 by means of a galvanic metal plating process.

The conductive circuit 10 of the printed circuit 1 defines a layout on the substrate 2 corresponding with the areas of the substrate 2 on which the catalytic ink has been printed. In the context of the invention, printing is understood to mean the process of catalytic ink deposition on the substrate 2 by mechanical printing means configured to print the catalytic ink in those areas of the substrate 2 defined in the layout of the conductive circuit 10.

A first nickel metal layer 4 is deposited on the catalytic ink layer 3 by means of an electroless metal plating process, also referred to as nickel plating, i.e., the first nickel metal layer 4 is deposited on those areas of the substrate 2 in which the catalytic ink layer 3 is printed. The catalytic ink is configured for initiating the electroless process whereby the nickel is deposited. The deposition of a nickel layer by means of an electroless metal plating process is a process that is known in the state of the art; therefore, the detailed description thereof is not considered necessary so that it can be understood and/or for the invention to be carried out.

A second copper metal layer 5 is deposited on the first nickel metal layer 4 by means of a galvanic metal plating process, therefore, after the galvanic metal plating process a copper layer will have been deposited on those areas of the substrate 2 on which the first nickel metal layer 4 had previously been deposited. The deposition of a copper layer by means of a galvanic metal plating process is a process that is known in the state of the art; therefore, the detailed description thereof is not considered necessary so that it can be understood and/or for the invention to be carried out.

The existence of the first nickel metal layer 4 causes the conductivity of the conductive circuit 10 of the printed circuit 1 of the invention to be better than the conductivity of the same kind of conductive circuits known in the state of the art.

The galvanic metal plating process is known to be much faster than the electroless metal plating process, i.e., for depositing one micron of a metal on a surface less time is needed if it is deposited by means of a galvanic metal plating process than by means of an electroless metal plating process. In the printed circuit 1 of the invention, the first nickel metal layer 4 deposited on the catalytic ink layer 3 by means of the electroless metal plating process has a minimum thickness, the thickness necessary for assuring adhesion of the copper metal layer, thereby minimizing the time used in the electroless metal plating process. In the context of the invention, the thickness of each layer is interpreted as the thickness or the height of each layer in the vertical direction when the printed circuit 1 is arranged such that it is supported on a horizontal surface. As shown in Figure 1, the thickness of the first nickel metal layer 4 corresponds with the distance shown as d, and the thickness of the second copper metal layer 5 corresponds with the distance referred to by means of d'.

The thickness of the second copper metal layer 5 is greater than the thickness of the first nickel metal layer 4, since it must be thick enough to assure proper conductivity of the conductive circuit 10. However, since it is deposited by means of the galvanic metal plating process, which is faster than the electroless process, the total manufacturing time for the printed circuit 1 of the invention with respect to manufacturing times for printed circuits known in the state of the art is reduced.

Furthermore, the use of a formaldehyde, a reducing agent used in the state of the art in electroless copper plating processes, is avoided in the manufacture of the printed circuit 1 of the invention. Formaldehyde is a hazardous compound so that, by avoiding it in the manufacturing process, the implementation of a number of safety measures aimed at assuring the safety of employees involved in said manufacturing process is avoided. For electroless nickel plating sodium hypophosphite, a weaker reducing agent than formaldehyde but sufficient for electroless nickel plating rather than copper plating, can be used.

In a preferred embodiment of the printed circuit 1, the conductive circuit 10 comprises a plurality of connection surfaces configured for allowing the connection of electronic components and a plurality of conductive tracks configured for connecting the plurality of connection surfaces to one another.

The conductive circuit 10 comprises a plurality of connection surfaces, i.e., a plurality of surfaces through which pins of the electronic components are welded to the printed circuit 1 and which allow said electronic components to be mounted on the printed circuit 1, with the conductive tracks being in charge of electrically connecting said connection surfaces. In the technical area of the printed circuits, the term pad is used to refer to said connection surfaces.

Conductive tracks are the paths or buses made of a conductive material arranged on the substrate 2.

The printed circuit 1 of the invention allows the welding of the electronic components to be carried out directly on the second copper metal layer 5 of the pads, since the pads of the printed circuit 1 of the invention are capable of withstanding the high temperatures that are reached during the electronic component welding process. Furthermore, the printed circuit 1 is capable of withstanding relatively higher powers than those supported by printed circuits known in the state of the art. In the preferred embodiment of the printed circuit 1, the electronic components are SMD components, i.e., they are surface mounted components.

In a preferred embodiment of the printed circuit 1, the width of the conductive tracks is between about 50 µm and about 500 µm. At present, the density of components in a printed circuit 1 is increasingly higher, which makes it necessary for the width of the conductive tracks to be increasingly smaller so as to allow a higher density of components on the substrate 2. In the context of the invention, width of a conductive track is understood to mean the distance in the horizontal direction between both sides of the conductive track when it is shown in a section view. In Figure 2, the width of the conductive track is shown as *h.*

In one embodiment of the printed circuit 1, the catalytic ink comprises one of the elements from groups 10 or 11 of the periodic table. The catalytic ink is configured for initiating the electroless process whereby the nickel layer is deposited, in which process the element from groups 10 or 11 of the periodic table acts as a process initiator.

In a preferred embodiment of the printed circuit 1, the catalytic ink comprises palladium.

In one embodiment, the printed circuit 1 comprises an additional conductive circuit 10' on at least part of a second face of the substrate 2. The additional conductive circuit 10' comprises an additional catalytic ink layer 3' printed by means of the catalytic ink printing process, a first additional metal layer 4' deposited on the additional catalytic ink layer 3' with the first additional metal layer 4' being a nickel layer deposited by means of the electroless metal plating process, and a second additional metal layer 5' deposited on the first additional metal layer 4' with the second additional metal layer 5' being a copper layer deposited by means of the galvanic metal plating process. The space of the substrate 2 is thereby optimized, the printed circuit 1 comprising conductive circuits on both faces of the substrate 2, wherein both conductive circuits have the same three-layer structure.

In one embodiment of the printed circuit 1, the thickness of the substrate 2 is between about 50 µm and about 200 µm, preferably being between about 100 µm and about 150 µm.

In the embodiment shown in Figure 1, the substrate 2 comprises a through opening 6 communicating the first face of the substrate 2 with the second face of the substrate 2, the printed circuit 1 comprising a catalytic ink connection layer 3" printed on the contour of the opening 6 by means of the catalytic ink printing process, a nickel metal connecting layer 4" deposited by means of the electroless metal plating process on the catalytic ink connection layer 3" printed on the contour of the opening 6, and a copper metal connecting layer 5" deposited by means of the galvanic metal plating process on the nickel metal connecting layer 4". The catalytic ink layer 3 printed on the first face of the substrate 2 and the additional catalytic ink layer 3' printed on the second face of the substrate 2 are electrically connected to one another through the catalytic ink connection layer 3", the first metal layer 4 and the first additional metal layer 4' are electrically connected to one another by means of the nickel metal connecting layer 4", and the second metal layer 5 and the second additional metal layer 5' are electrically connected to one another by means of the copper metal connecting layer 5".

During the catalytic ink printing process, both when the catalytic ink is printed on the first face of the substrate 2 and when it is printed on the second face of the substrate 2, due to the small thickness of the substrate 2 said catalytic ink also impregnates the contour of the opening 6, giving rise to the catalytic ink connection layer 3". The catalytic ink connection layer 3" is a catalytic ink layer printed on the contour of the opening 6. Subsequently, in the electroless metal plating process, due to the presence of the catalytic ink, the nickel metal connecting layer 4" is deposited on the catalytic ink connection layer 3", just like it is deposited on the catalytic ink layer 3 printed on the first face of the substrate 2, and on the additional catalytic ink layer 3' printed on the second face of the substrate 2. Likewise, in the galvanic metal plating process, and due to the existence of nickel in the nickel metal connecting layer 4", the copper metal connecting layer 5" will be deposited on the previously deposited nickel metal connecting layer 4", just like it is deposited on the first nickel metal layer 4 existing on the first face of the substrate 2, and on the first additional nickel metal layer 4' existing on the second face of the substrate 2.

The opening 6 has a minimum diameter which allows the deposition of the catalytic ink connection layer 3", the nickel metal connecting layer 4", and the copper metal connecting layer 5" on the contour of the opening 6. Furthermore, it is necessary when making said opening 6 not to generate rough edges protruding above any of the faces of the substrate 2.

In a preferred embodiment of the printed circuit 1, the opening 6 has a diameter of between about 100 µm and about 500 µm.

In a preferred embodiment of the invention, the opening 6 is made by means of a femtosecond laser. The femtosecond laser is configured for making very precise openings 6 at relatively low temperatures which do not jeopardize the substrate 2 of the printed circuit 1 and prevent rough edges from being generated on the contour of the opening 6 protruding above the faces of the substrate 2 which would prevent the catalytic ink from being deposited on the contour of the opening 6. In another embodiment, the opening 6 is not a through opening having a constant section, but rather the opening 6 comprises a first bevel in the upper part of the opening 6 in the transition to the first face of the substrate 2, and a second bevel in the lower part of the opening 6 in the transition to the second face of the substrate 2, wherein both bevels have been made by means of the femtosecond laser and facilitate penetration of the catalytic ink into the opening 6 during the printing process.

In a preferred embodiment of the printed circuit 1, the thickness of the first metal layer 4 is between about 0.3 µm and about 0.7 µm. This range of thicknesses achieves, on one hand, the thickness of the first metal layer 4 being minimally the thickness needed to assure adhesion of the second copper metal layer 5, and in turn not to be excessive so that the first metal layer 4 does not crack.

In a preferred embodiment of the printed circuit 1, the thickness of the second metal layer 5 is at least 12 µm. The thickness of the second metal layer is thereby sufficient to assure proper electrical conductivity with low Joule effect losses, and so that the electronic components can be welded directly to the second copper metal layer 5. The greater the thickness of the second metal layer 5, the longer the manufacturing time that is required, and at the same time, the greater the risk of the second metal layer 5 cracking should the substrate 2 bend.

In one embodiment of the printed circuit 1, the catalytic ink layer 3, 3', 3" is a screen-printed layer. However, in another embodiment of the printed circuit 1, the catalytic ink layer 3, 3', 3" is a layer printed by means of ink jet. In another embodiment, a flexographic printing machine with blade chamber inking system, also known as a doctor blade machine, can be used. However, the described printing means are not intended to be a limitation of the invention, and in other embodiments other printing means known in the state of the art could be used.

In a preferred embodiment of the printed circuit 1, the substrate 2 is flexible. This makes it possible for being able to manufacture the printed circuit 1 by means of a continuous manufacturing process in which the flexible substrate 2 is initially rolled up and is gradually unrolled when going through the different phases of said process. There are multiple flexible substrates on the market that can be used in the printed circuit 1 of the invention, such as PET (polyethylene terephthalate), PEN (polyethylene naphthalate) and PI (polyimide). However, this selection is not intended to be a limitation of the invention, and in other embodiments other flexible substrates known in the state of the art could be used. Since the substrate 2 is a flexible substrate, the printed circuit 1 can adopt a non-planar shape. Therefore, when the printed circuit 1 is positioned within a support or is fixed to a support, the flexibility of the printed circuit 1 allows said printed circuit 1 to be able to adopt non-planar shapes, where it can therefore be adapted to supports with non-planar morphologies or shapes, even after welding the electronic components to the printed circuit 1. In other embodiments, the substrate could be a non-flexible substrate.

In a preferred embodiment of the printed circuit 1, the substrate 2 is made of a plastic material.

In a preferred embodiment of the printed circuit 1, the substrate 2 is transparent. When luminous elements such as LEDs or displays are fixed to a face of the substrate 2, the transparency of the substrate 2 allows the light emitted by said luminous elements to be seen from the other face of the substrate 2. In one embodiment of the printed circuit 1 in which the substrate 2 is flexible and transparent, preferably PET, at least one capacitive button is fixed or printing on a first face of the substrate 2. The thickness of the capacitive button and the thickness of the conductive circuit 10 are very small, in the order of tens of µm, which allows the first face of the printed circuit 1 to be fixed directly to a first face of the support, where the printed circuit 1 can be adapted to the shape of the support. In one embodiment, the first face of the printed circuit 1 is adhered directly to the first face of the support. However, in other embodiments the first face of the printed circuit 1 is fixed to the first face of the support by elastic pushing means configured for pushing the printed circuit 1 against the first face of the support 1. In other embodiments, the first face of the printed circuit 1 is adhered to the first face of the support by other fixing means known in the state of the art. At least one luminous element and the rest of the electronic components are fixed on the second face of the substrate. In this embodiment of the printed circuit 1, the support is transparent or has at least one transparent area, such that the light emitted by the luminous element through the support or said transparent area and through the substrate 2 can be seen from a second face of the support opposite the first face. Furthermore, since the first face of the substrate 2 is in direct contact with the support, the capacitive buttons printed on the first face of the substrate are in direct contact with the support. This makes it possible for said capacitive buttons to be much more precise and to be more sensitive than capacitive buttons known in the state of the art, which had to comprise pushing means that pushed the capacitive button against the support to assure contact thereof with said support. All this further contributes to mounting the printed circuit 1 with capacitive buttons being easier.

In another embodiment of the printed circuit 1, the substrate 2 is a fabric.

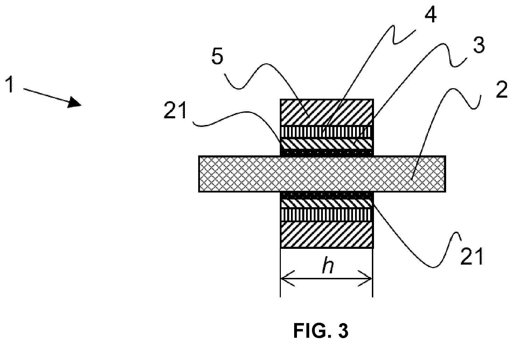

Figure 3 shows an embodiment of the printed circuit 1 comprising an electrical insulating layer 21 between the substrate 2 and the conductive circuit 10, with the substrate 2 being a metal substrate. Multiple methods for generating an electrical insulating layer 21 are known in the state of the art. In one embodiment, the electrical insulating layer 21 is generated by means of a PVD coating, being cured by means of laser or NIR. However, said example is not intended to be a limitation of the invention, where the electrical insulating layer 21 can be generated by means of any other method known in the state of the art.

In one embodiment of the printed circuit 1, the electrical insulating layer 21 is made of a glass insulating material. Printing with special inks which, after a sintering process, generate a sintered glass frit, which is commonly used as an insulating material, is known in the state of the art. However, this example is not intended to be a limitation of the invention, where the glass insulating layer can be generated by means of another method known in the state of the art.

In another embodiment of the printed circuit 1, the electrical insulating layer 21 is an oxide layer of the metal of the substrate 2.

In one embodiment of the printed circuit 1, the substrate 2 is an alloy comprising aluminum. In this embodiment, the electrical insulating layer 21 is an alumina layer, and the substrate 2 is preferably FeCrAl.

Lastly, an electronic device may comprise a plastic body including a printed circuit according to the invention, at least partially embedded in said plastic body.

## Claims

1. Printed circuit comprising a substrate (2), and a conductive circuit (10) on at least part of a first face of the substrate (2), the conductive circuit (10) comprising a catalytic ink layer (3) printed on part of the first face of the substrate (2), a first metal layer (4) deposited on the catalytic ink layer (3), and a second metal layer (5) deposited on the first metal layer (4), with the first metal layer (4) being a nickel layer deposited on the catalytic ink layer (3) by means of an electroless metal plating process, and with the second metal layer (5) being a copper layer deposited on the first metal layer (4) by means of a galvanic metal plating process, **characterized in that** the printed circuit comprises an additional conductive circuit (10') on at least part of a second face of the substrate (2), the additional conductive circuit (10') comprising an additional catalytic ink layer (3') printed by means of the catalytic ink printing process, a first additional metal layer (4') deposited on the additional catalytic ink layer (3') with the first additional metal layer (4') being a nickel layer deposited by means of the electroless metal plating process, and a second additional metal layer (5') deposited on the first additional metal layer (4') with the second additional metal layer (5') being a copper layer deposited by means of the galvanic metal plating process, the substrate (2) comprises a through opening (6) communicating the first face of the substrate (2) with the second face of the substrate (2), and the printed circuit (1) comprises a catalytic ink connection layer (3") printed on the contour of the opening (6) by means of the catalytic ink printing process, a nickel metal connecting layer (4") deposited by means of the electroless metal plating process on the catalytic ink connection layer (3") printed on the contour of the opening (6), and a copper metal connecting layer (5") deposited by means of the galvanic metal plating process on the nickel metal connecting layer (4"), such that the catalytic ink layer (3) printed on the first face of the substrate (2) and the additional catalytic ink layer (3') printed on the second face of the substrate (2) are electrically connected to one another through the catalytic ink connection layer (3"), with the first metal layer (4) and the first additional metal layer (4') being electrically connected to one another by means of the nickel metal connecting layer (4"), and with the second metal layer (5) and the second additional metal layer (5') being electrically connected to one another by means of the copper metal connecting layer (5").

2. Printed circuit according to claim 1, wherein the conductive circuit (10) comprises a plurality of connection surfaces configured for allowing the connection of electronic components and a plurality of conductive tracks configured for connecting the plurality of connection surfaces to one another.

3. Printed circuit according to claim 2, wherein the width of each conductive track is between about 50 µm and about 500 µm.

4. Printed circuit according to any of the preceding claims, wherein the catalytic ink comprises one of the elements from groups 10 or 11 of the periodic table, preferably palladium.

5. Printed circuit according to any of the preceding claims, wherein the opening (6) has a diameter of between about 100 µm and about 500 µm.

6. Printed circuit according to any of the preceding claims, wherein the thickness of the first metal layer (4) is between about 0.3 µm and about 0.7 µm, and the thickness of the second metal layer (5) is at least 12 µm.

7. Printed circuit according to any of the preceding claims, wherein the catalytic ink layer (3, 3', 3") is a screen-printed layer or a layer printed by means of ink jet.

8. Printed circuit according to any of the preceding claims, wherein the substrate (2) is flexible.

9. Printed circuit according to any of the preceding claims, wherein the substrate (2) is made of a plastic and/or a transparent material, or the substrate (2) is a fabric.

10. Printed circuit according to any of claims 1 to 8, comprising an electrical insulating layer between the substrate (2) and the conductive circuit (10), with the substrate (2) being a metal substrate.

11. Printed circuit according to claim 10, wherein the electrical insulating layer is made of a glass insulating material.

12. Printed circuit according to claim 10, wherein the electrical insulating layer is an oxide layer of the metal of the substrate (2).

13. Printed circuit according to claim 12, wherein the substrate (2) is an alloy comprising aluminum.

## Patentansprüche

1. Leiterplatte, umfassend ein Substrat (2) und eine leitende Schaltung (10) auf mindestens einem Teil einer ersten Seite des Substrats (2), wobei die leitende Schaltung (10) eine Schicht katalytischer Druckfarbe (3), die auf einen Teil der ersten Seite des Substrats (2) gedruckt ist, eine erste Metallschicht (4), die auf der Schicht katalytischer Druckfarbe (3) abgeschieden ist, und eine zweite Metallschicht (5), die auf der ersten Metallschicht (4) abgeschieden ist, umfasst, wobei die erste Metallschicht (4) eine Nickelschicht ist, die auf der Schicht katalytischer Druckfarbe (3) mittels eines stromlosen Metallplattierungsverfahrens abgeschieden ist, und wobei die zweite Metallschicht (5) eine Kupferschicht ist, die auf der ersten Metallschicht (4) mittels eines galvanischen Metallplattierungsverfahrens abgeschieden ist, **dadurch gekennzeichnet, dass** die Leiterplatte eine zusätzliche leitende Schaltung (10') auf mindestens einem Teil einer zweiten Seite des Substrats (2) umfasst, wobei die zusätzliche leitende Schaltung (10') eine zusätzliche Schicht katalytischer Druckfarbe (3'), die mittels des Druckverfahrens für katalytische Druckfarbe gedruckt ist, eine erste zusätzliche Metallschicht (4'), die auf der zusätzlichen Schicht katalytischer Druckfarbe (3') abgeschieden ist, wobei die erste zusätzliche Metallschicht (4') eine Nickelschicht ist, die mittels des stromlosen Metallplattierungsverfahrens abgeschieden ist, und eine zweite zusätzliche Metallschicht (5') umfasst, die auf der ersten zusätzlichen Metallschicht (4') abgeschieden ist, wobei die zweite zusätzliche Metallschicht (5') eine Kupferschicht ist, die mittels des galvanischen Metallplattierungsverfahrens abgeschieden ist, wobei das Substrat (2) eine Durchgangsöffnung (6) umfasst, die die erste Seite des Substrats (2) mit der zweiten Seite des Substrats (2) verbindet, und die Leiterplatte (1) eine Verbindungsschicht katalytischer Druckfarbe (3"), die auf den Umriss der Öffnung (6) mittels des Druckverfahrens für katalytische Druckfarbe gedruckt ist, eine Nickelmetall-Verbindungsschicht (4"), die mittels des stromlosen Metallplattierungsverfahrens auf die Verbindungsschicht katalytischer Druckfarbe (3") abgeschieden ist, die auf den Umriss der Öffnung (6) gedruckt ist, und eine Kupfermetall-Verbindungsschicht (5") umfasst, die mittels des galvanischen Metallplattierungsverfahrens auf der Nickelmetall-Verbindungsschicht (4") abgeschieden ist, so dass die Schicht katalytischer Druckfarbe (3), die auf die erste Seite des Substrats (2) gedruckt ist, und die zusätzliche Schicht katalytischer Druckfarbe (3'), die auf die zweite Seite des Substrats (2) gedruckt ist, durch die Verbindungsschicht katalytischer Druckfarbe (3") elektrisch miteinander verbunden sind, wobei die erste Metallschicht (4) und die erste zusätzliche Metallschicht (4') mittels der Nickelmetall-Verbindungsschicht (4") elektrisch miteinander verbunden sind und wobei die zweite Metallschicht (5) und die zweite zusätzliche Metallschicht (5') mittels der Kupfermetall-Verbindungsschicht (5") elektrisch miteinander verbunden sind.

2. Leiterplatte nach Anspruch 1, wobei die leitende Schaltung (10) eine Vielzahl von Verbindungsoberflächen, die dazu konfiguriert sind, die Verbindung von elektronischen Komponenten zu ermöglichen, und eine Vielzahl von Leiterbahnen umfasst, die dazu konfiguriert sind, die Vielzahl von Verbindungsoberflächen miteinander zu verbinden.

3. Leiterplatte nach Anspruch 2, wobei die Breite jeder Leiterbahn zwischen etwa 50 µm und etwa 500 µm liegt.

4. Leiterplatte nach einem der vorhergehenden Ansprüche, wobei die katalytische Druckfarbe eines der Elemente der 10. oder 11. Gruppe des Periodensystems umfasst, vorzugsweise Palladium.

5. Leiterplatte nach einem der vorhergehenden Ansprüche, wobei die Öffnung (6) einen Durchmesser zwischen etwa 100 µm und etwa 500 µm aufweist.

6. Leiterplatte nach einem der vorhergehenden Ansprüche, wobei die Dicke der ersten Metallschicht (4) zwischen etwa 0,3 µm und etwa 0,7 µm liegt und die Dicke der zweiten Metallschicht (5) mindestens 12 µm beträgt.

7. Leiterplatte nach einem der vorhergehenden Ansprüche, wobei die Schicht katalytischer Druckfarbe (3, 3', 3") eine im Siebdruckverfahren gedruckte Schicht oder eine mittels Tintenstrahldruck gedruckte Schicht ist.

8. Leiterplatte nach einem der vorhergehenden Ansprüche, wobei das Substrat (2) flexibel ist.

9. Leiterplatte nach einem der vorhergehenden Ansprüche, wobei das Substrat (2) aus einem Kunststoff und/oder einem transparenten Material besteht oder das Substrat (2) ein Gewebe ist.

10. Leiterplatte nach einem der Ansprüche 1 bis 8, umfassend eine elektrische Isolierschicht zwischen dem Substrat (2) und der leitenden Schaltung (10), wobei das Substrat (2) ein Metallsubstrat ist.

11. Leiterplatte nach Anspruch 10, wobei die elektrische Isolierschicht aus einem glasisolierenden Material besteht.

12. Leiterplatte nach Anspruch 10, wobei die elektrische Isolierschicht eine Oxidschicht des Metalls des Substrats (2) ist.

13. Leiterplatte nach Anspruch 12, wobei das Substrat (2) eine Aluminium umfassende Legierung ist.

## Revendications

1. Circuit imprimé comprenant un substrat (2) et un circuit conducteur (10) sur au moins une partie d'une première face du substrat (2), le circuit conducteur (10) comprenant une couche d'encre catalytique (3) imprimée sur une partie de la première face du substrat (2), une première couche métallique (4) déposée sur la couche d'encre catalytique (3), et une deuxième couche métallique (5) déposée sur la première couche métallique (4), la première couche métallique (4) étant une couche de nickel déposée sur la couche d'encre catalytique (3) au moyen d'un procédé de dépôt métallique autocatalytique, et la deuxième couche métallique (5) étant une couche de cuivre déposée sur la première couche métallique (4) au moyen d'un procédé de dépôt métallique galvanique, **caractérisé en ce que** le circuit imprimé comprend un circuit conducteur additionnel (10') sur au moins une partie d'une deuxième face du substrat (2), le circuit conducteur additionnel (10') comprenant une couche d'encre catalytique additionnelle (3') imprimée au moyen du procédé d'impression d'encre catalytique, une première couche métallique additionnelle (4') déposée sur la couche d'encre catalytique additionnelle (3'), la première couche métallique additionnelle (4') étant une couche de nickel déposée au moyen du procédé de dépôt métallique autocatalytique, et une deuxième couche métallique additionnelle (5') déposée sur la première couche métallique additionnelle (4'), la deuxième couche métallique additionnelle (5') étant une couche de cuivre déposée au moyen du procédé de dépôt métallique galvanique, le substrat (2) comprend une ouverture traversante (6) qui met en communication la première face du substrat (2) avec la deuxième face du substrat (2), et le circuit imprimé (1) comprend une couche de connexion d'encre catalytique (3") imprimée sur le contour de l'ouverture (6) au moyen du procédé d'impression d'encre catalytique, une couche de connexion de métal de nickel (4") déposée au moyen du procédé de dépôt métallique autocatalytique sur la couche de connexion d'encre catalytique (3") imprimée sur le contour de l'ouverture (6), et une couche de connexion de métal de cuivre (5") déposée au moyen du procédé de dépôt métallique galvanique sur la couche de connexion de métal de nickel (4"), de sorte que la couche d'encre catalytique (3) imprimée sur la première face du substrat (2) et la couche d'encre catalytique additionnelle (3') imprimée sur la deuxième face du substrat (2) sont connectées électriquement l'une à l'autre à travers la couche de connexion d'encre catalytique (3"), la première couche métallique (4) et la première couche métallique additionnelle (4') étant connectées électriquement l'une à l'autre au moyen de la couche de connexion de métal de nickel (4"), et la deuxième couche métallique (5) et la deuxième couche métallique additionnelle (5') étant connectées électriquement l'une à l'autre au moyen de la couche de connexion de métal de cuivre (5").

2. Circuit imprimé selon la revendication 1, dans lequel le circuit conducteur (10) comprend une pluralité de surfaces de connexion configurées pour permettre la connexion de composants électroniques et une pluralité de pistes conductrices configurées pour connecter la pluralité de surfaces de connexion les unes aux autres.

3. Circuit imprimé selon la revendication 2, dans lequel la largeur de chaque piste conductrice est comprise entre environ 50 µm et environ 500 µm.

4. Circuit imprimé selon l'une quelconque des revendications précédentes, dans lequel l'encre catalytique comprend l'un des éléments des groupes 10 ou 11 de la table périodique, de préférence le palladium.

5. Circuit imprimé selon l'une quelconque des revendications précédentes, dans lequel l'ouverture (6) présente un diamètre compris entre environ 100 µm et environ 500 µm.

6. Circuit imprimé selon l'une quelconque des revendications précédentes, dans lequel l'épaisseur de la première couche métallique (4) est compris entre environ 0,3 µm et environ 0,7 µm, et l'épaisseur de la deuxième couche métallique (5) est d'au moins 12 µm.

7. Circuit imprimé selon l'une quelconque des revendications précédentes, dans lequel la couche d'encre catalytique (3, 3', 3") est une couche sérigraphiée ou une couche imprimée au moyen d'un jet d'encre.

8. Circuit imprimé selon l'une quelconque des revendications précédentes, dans lequel le substrat (2) est flexible.

9. Circuit imprimé selon l'une quelconque des revendications précédentes, dans lequel le substrat (2) est fait en plastic et/ou un matériau transparent, ou le substrat (2) est un matériau textile.

10. Circuit imprimé selon l'une quelconque des revendications 1 à 8, comprenant une couche d'isolement électrique entre le substrat (2) et le circuit conducteur (10), le substrat (2) étant un substrat métallique.

11. Circuit imprimé selon la revendication 10, dans lequel la couche d'isolement électrique est faite en un matériau isolant en verre.

12. Circuit imprimé selon la revendication 10, dans lequel la couche d'isolement électrique est une couche d'oxyde du métal du substrat (2).

13. Circuit imprimé selon la revendication 12, dans lequel le substrat (2) est un alliage comprenant de l'aluminium.
